(19) Europäisches Patentamt
European Patent Office
Office européen des brevets

(11) **EP 4 598 285 A1**

(12) **EUROPEAN PATENT APPLICATION**
published in accordance with Art. 153(4) EPC

(43) Date of publication:
**06.08.2025 Bulletin 2025/32**

(21) Application number: **23873279.6**

(22) Date of filing: **27.09.2023**

(51) International Patent Classification (IPC):
**H05K 3/26** *(2006.01)* **H05K 1/11** *(2006.01)*

(52) Cooperative Patent Classification (CPC):
**H05K 1/11; H05K 3/26**

(86) International application number:
**PCT/KR2023/015150**

(87) International publication number:
**WO 2024/072172 (04.04.2024 Gazette 2024/14)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **30.09.2022 KR 20220125167**

(71) Applicant: **Koh Young Technology Inc.**
**Seoul 08588 (KR)**

(72) Inventors:
• **LEE, Jae Hwan**
  **Seoul 04574 (KR)**
• **KIM, Hyeong Soo**
  **Cheonan-si, Chungcheongnam-do 31212 (KR)**
• **YOO, Yong Ho**
  **Daejeon 34140 (KR)**
• **KANG, Jin Man**
  **San Diego, California 92129 (US)**

(74) Representative: **Meissner Bolte Partnerschaft mbB**
**Patentanwälte Rechtsanwälte**
**Postfach 86 06 24**
**81633 München (DE)**

(54) **DEVICE AND METHOD FOR DETERMINING OPTIMAL CLEANING CYCLE OF SCREEN PRINTER, AND RECORDING MEDIUM ON WHICH INSTRUCTIONS ARE RECORDED**

(57) Disclosed is technology for determining an optimal cleaning cycle for a screen printer. An apparatus according to an aspect of the present disclosure may include one or more processors, and one or more memories storing instructions, which, when executed by the one or more processors, enable the one or more processors to perform an operation, wherein the one or more processors perform determining, based on at least one index indicating states of solder paste printed on a plurality of circuit boards, a plurality of anomaly scores indicating print qualities of the plurality of circuit boards, generating, based on the plurality of anomaly scores, estimated data indicating a degree of deterioration of a print quality of an $N^{th}$ circuit board when sequentially printing N circuit boards without cleaning a screen printer, and determining a cleaning cycle based on the estimated data and an amount of resources consumed when cleaning of the screen printer is performed, wherein the cleaning cycle may correspond to a number of circuit boards printed by the screen printer after the screen printer is cleaned and before a start of subsequent cleaning.

FIG. 7

**Description**

TECHNICAL FIELD

The present disclosure relates to technology for determining an optimal cleaning cycle for a screen printer.

BACKGROUND

A process in which solder paste is printed on a printed circuit board (PCB) may be performed by a screen printer. During a solder paste printing process, stencil cleaning is performed in inefficient cycles since the amount of residual solder paste accumulated in the stencil is not taken into consideration, which is a drawback.

SUMMARY

The present disclosure provides a technology that can determine an optimal cleaning cycle.

An apparatus according to an aspect of the present disclosure may include one or more processors, and one or more memories storing instructions, which, when executed by the one or more processors, enable the one or more processors to perform an operation, wherein the one or more processors may determine, based on at least one index indicating states of solder paste printed on a plurality of circuit boards, a plurality of anomaly scores indicating print qualities of the plurality of circuit boards, respectively, may generate, based on the plurality of anomaly scores, estimated data indicating a degree of deterioration of a print quality of an $N^{th}$ circuit board when sequentially printing N circuit boards without cleaning a screen printer, and may determine a cleaning cycle based on the estimated data and an amount of resources consumed when cleaning the screen printer is performed, wherein the cleaning cycle corresponds to a number of circuit boards printed by the screen printer after the screen printer is cleaned and before a start of subsequent cleaning.

According to one embodiment, the one or more processors may determine a weight corresponding to each of the at least one index, may determine an estimation range of the at least one index, and may determine, based on the weight and a degree by which each of the at least one index deviates from the estimation range, the plurality of anomaly scores of the plurality of circuit boards, respectively.

According to one embodiment, the one or more processors may determine an anomaly score for each of a plurality of pad groups distinguished based on a shape of a pad, and may determine, based on the anomaly score for each of the plurality of pad groups, the plurality of anomaly scores of the plurality of circuit boards, respectively.

According to one embodiment, the one or more processors may determine, based on the number of pads included in each of the plurality of pad groups, a weight for each pad group, and may determine, based on the anomaly score for each pad group and the weight for each pad group, the plurality of anomaly scores for the plurality of circuit boards, respectively.

According to one embodiment, the one or more processors may determine a weight for a pad group, of which the number of pads included in the pad group is less than or equal to a predetermined number among the plurality of pad groups, to be 0.

According to one embodiment, the at least one index may include at least one among a degree of excess of printed solder paste, a degree of insufficiency of printed solder paste, a standard deviation in the amount of printed solder paste, and a degree of deviation of a circuit board and a stencil from an aligned location.

According to one embodiment, the apparatus may further include a communication circuit connected to be capable of communicating with the screen printer, wherein the communication circuit may transmit the cleaning cycle to the screen printer, and in response to reception of the cleaning cycle, the screen printer may perform a predetermined operation for cleaning based on the cleaning cycle.

According to one embodiment, the one or more processors may generate the estimated data using survival analysis.

According to one embodiment, the resources consumed when cleaning is performed may include a cost for purchasing itmes and a time needed for cleaning the screen printer.

According to one embodiment, the one or more processors may determine, based on the estimated data and the cost for purchases and the time needed for cleaning the screen printer, the cleaning cycle so that the amount of resources consumed for cleaning the screen printer and deterioration in print quality are minimized.

According to one embodiment, the one or more processors may continuously obtain the at least one index and store the same in the one or more memories, and may update the cleaning cycle based on data stored in the one or more memories, after cleaning is performed a predetermined number of times.

A method according to another aspect of the present disclosure may include an operation of determining, based on at least one index indicating states of solder paste printed on a plurality of circuit boards, a plurality of anomaly scores indicating print qualities of the plurality of circuit boards, respectively, an operation of generating, based on the plurality of anomaly scores, estimated data indicating a degree of deterioration of a quality of an $N^{th}$ circuit board when sequentially printing N circuit boards without cleaning a screen printer, and an operation of determining a cleaning cycle based on the estimated data and the amount of resources consumed when cleaning of the screen printer is performed, wherein the cleaning cycle may correspond to a number of circuit boards printed by the screen printer after the screen printer is cleaned and before a start of subsequent cleaning.

According to one embodiment, the operation of determining the anomaly scores may include an operation of determining a weight corresponding to each of the at least one index, an operation of determining an estimation range of the at least one index, and an operation of determining, based on the weight and a degree by which each of the at least one index deviates from the estimation range, the plurality of anomaly scores of the plurality of circuit boards, respectively.

According to one embodiment, the operation of determining the anomaly scores may include an operation of determining an anomaly score for each of a plurality of pad groups distinguished based on a shape of a pad, and an operation of determining, based on the anomaly score for each pad group, the plurality of anomaly scores of the plurality of circuit boards, respectively.

According to one embodiment, the operation of determining the anomaly scores may include an operation of determining, based on a number of pads included in each of the plurality of pad groups, a weight for each pad group, and an operation of determining, based on the anomaly score for each pad group and the weight for each pad group, the plurality of anomaly scores for the plurality of circuit boards, respectively.

According to one embodiment, the operation of determining the weight for each of the plurality of pad groups may further include an operation of determining a weight for a pad group, of which the number of pads included in the pad group is less than or equal to a predetermined number among the plurality of pad groups, to be 0.

According to one embodiment, the at least one index may include at least one among a degree of excess of printed solder paste, a degree of insufficiency of printed solder paste, a standard deviation in the amount of printed solder paste, and a degree of deviation of a circuit board and a stencil from an aligned location.

According to one embodiment, the operation of generating the estimated data may include an operation of generating the estimated data using survival analysis.

According to one embodiment, the operation of determining the cleaning cycle may include an operation of continuously obtaining the at least one index and storing the at least one index in a memory, and an operation of updating, based on data stored in the memory, the cleaning cycle after cleaning is performed a predetermined number of times.

According to another aspect of the present disclosure, in a non-transitory computer-readable recording medium that stores instructions which, when executed by one or more processors, enable the one or more processors to perform an operation, the instructions may include operations in which the one or more processors determine, based on at least one index indicating states of solder paste printed on a plurality of circuit boards, a plurality of anomaly scores indicating print qualities of the plurality of circuit boards, respectively, generate, based on the plurality of anomaly scores, estimated data indicating a degree of deterioration of quality of an $N^{th}$ circuit board when sequentially printing N circuit boards without cleaning a screen printer, and determine a cleaning cycle based on the estimated data and an amount of resources consumed when cleaning of the screen printer is performed, wherein the cleaning cycle may correspond to the number of circuit boards printed by the screen printer after the screen printer is cleaned and before a start of subsequent cleaning.

According to various embodiments of the present disclosure, a cleaning cycle for cleaning a screen printer may be determined so that the print quality of a printed circuit board is appropriately maintained and a printing process is not delayed. Accordingly, a cleaning cycle may be efficiently determined when compared to technology that determines a cleaning cycle according to a value that a user manually inputs.

BRIEF DESCRIPTION OF DRAWINGS

FIG. 1 is a block diagram schematically illustrating a configuration of an apparatus for determining a cleaning cycle, according to an embodiment of the present disclosure.

FIG. 2 is a diagram illustrating a stencil to which residual solder paste is accumulated, according to an embodiment of the present disclosure.

FIG. 3 is a graph illustrating measurement data of an index indicating a state of solder paste and an estimation range, according to an embodiment of the present disclosure.

FIG. 4 is a diagram illustrating an embodiment in which an apparatus according to an embodiment of the present disclosure determines an anomaly score for each pad group, and determines an anomaly score of a circuit board based on the anomaly score for each pad group.

FIG. 5 is a diagram illustrating an embodiment in which an apparatus according to an embodiment of the present disclosure determines an anomaly score of a printed circuit board according to measurement data of an index indicating the state of solder paste.

FIG. 6 is a diagram illustrating an embodiment in which an apparatus according to an embodiment of the present disclosure determines an optimal cleaning cycle based on measurement data and an amount of resources consumed for cleaning a screen printer, using survival analysis.

FIG. 7 is a diagram illustrating an embodiment in which an apparatus according to an embodiment of the present disclosure determines an optimal cleaning cycle by using measurement data and survival analysis.

FIG. 8 is a flowchart illustrating a method of determining an optimal cleaning cycle by an apparatus according to an embodiment of the present disclosure.

DETAILED DESCRIPTION

Various embodiments of the present disclosure are illustrated for describing the technical spirit of the present disclosure, and are not intended to limit the technical sprit to a predetermined embodiment. The technical spirit of the present disclosure may include various modifications, equivalents, alternatives of each embodiment specified in the present disclosure, and an embodiment obtained by selectively combining the entire or a part of each embodiment. In addition, the scope of rights according to the technical spirit of the present disclosure is not limited to the various embodiments described below or to the detailed descriptions of these embodiments.

All terms used herein, including technical or scientific terms, have meanings that are generally understood by a person having ordinary knowledge in the art to which the present disclosure pertains, unless otherwise specified.

The expressions "include," "may include," "provided with," "may be provided with," "have," "may have" and the like used herein may imply that characteristics (e.g., a function, an operation, a component, or the like) to be applied are present, and may not exclude the existence of other additional characteristics. That is, the expressions should be understood as open-ended terms connoting the possibility of inclusion of other embodiments.

A singular expression used herein can include meanings of plural expression, unless otherwise mentioned, and the same is applied to a singular expression recited in the claims.

The terms "1st", " "2nd," "first," "second," or the like used herein are used to distinguish a plurality of components from one another, unless used as a different meaning in context, and are not intended to limit the order or importance of the relevant components.

The expressions "A, B, and C," "A, B, or C," "A, B, and/or C," or "at least one of A, B, and C," "at least one of A, B, or C," "at least one of A, B, and/or C," or the like used herein may imply every arranged items or all possible combinations of the arranged items. For example, "at least one of A or B" may imply all of (1) at least one A, (2) at least one B, and (3) at least one A and at least one B.

The expression "based on" used herein is used to describe one or more factors that influences a decision, an action of judgment or an operation described in a phrase or sentence including the relevant expression, and this expression does not exclude an additional factor influencing the decision, the action of judgment or the operation.

When a certain component (e.g., a first component) is described using the expression used herein, such as "coupled to" or "connected to" another component (e.g., a second component), this should be understood as having a meaning that the certain component may be coupled or connected directly to the other component or that the certain component may be coupled or connected to the other component via a new intervening component (e.g., a third component).

The expression "configured to" used herein has meanings of "set to," "having a capability of," "modified to," "made to," "being capable of," or the like depending on context. The corresponding expression is not be limited to the meaning of "specially designed in hardware manner," and, for example, a processor configured to perform a predetermined operation may be a generic-purpose processor capable of performing the predetermined operation by executing software.

Hereinafter, various embodiments of the present disclosure will be described with reference to the accompanying drawings. In the enclosed drawings and the descriptions thereof, like or substantially equivalent components may be assigned with like reference numerals. In addition, in the descriptions of various embodiments provided below, redundant description of like or corresponding components may be omitted. However, it does not imply that the corresponding components are not included in a corresponding embodiment.

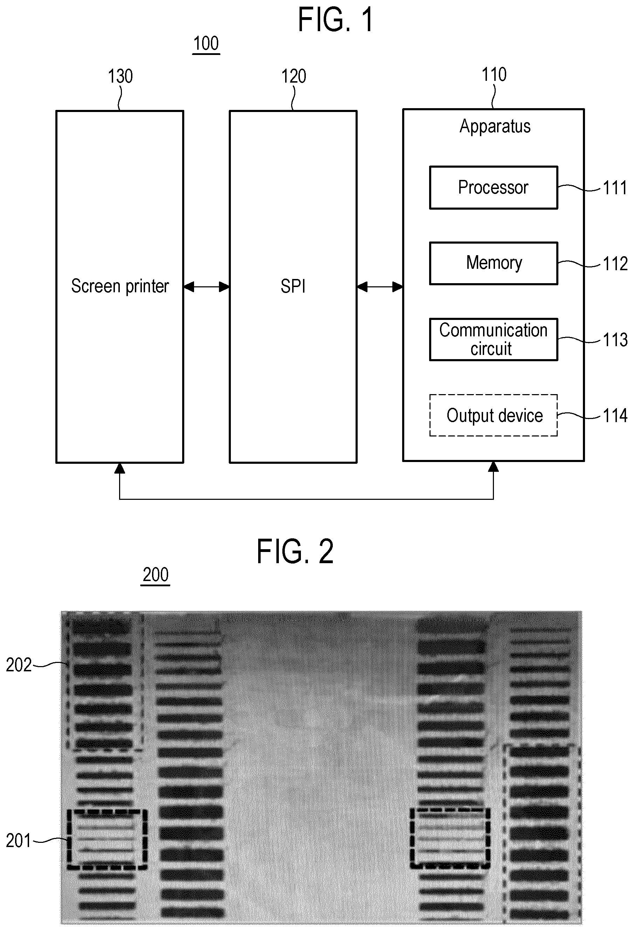

FIG. 1 is a block diagram schematically illustrating a configuration of an apparatus for determining a cleaning cycle, according to an embodiment of the present disclosure. According to various embodiments of the present disclosure, an apparatus 110 may include a processor 111, a memory 112, and a communication circuit 113. In addition, the apparatus 110 may further include an output device 114 to output a result obtained via processing by the processor 111. In some embodiments, at least one of the components of the apparatus 110 may be omitted, or another component may be added to the apparatus 110. In some embodiments, additionally or alternatively, some components may be combined and embodied as a single entity, or may be embodied as a single entity or a plurality of entities.

At least some of the components disposed inside or outside an electronic device may be connected to each other via a bus, a general purpose input/output (GPIO), a serial peripheral interface (SPI), or a mobile industry processor interface (MIPI), or the like, and may transmit or receive data and/or signals.

The apparatus 110 (e.g., an electronic device) may be an apparatus provided in one of the various forms. For example, the apparatus may be provided as one of a portable communication device, a computer device, a portable multimedia device, a wearable device, and an electronic appliance device, or may be provided as a combination of one or more of the above-described devices. The apparatus of the present disclosure is not limited to the above-described devices.

The processor 111 may execute software so as to control at least one component of the apparatus 110 connected to the processor 111. In addition, the processor 111 may perform operations such as various operations, processing, data generation, manufacturing, or the like related to the present disclosure. In addition, the processor 111 may load data or the like from the memory 112, or may store the same in the memory 112.

The memory 112 may store various data. The data stored in the memory 112 may include software as data obtained, processed, or used by at least one component of the apparatus 110. The memory 112 may include a volatile and/or non-volatile memory.

The communication circuit 113 may perform wired or wireless communication between the apparatus 110 and another external electronic device. For example, the communication circuit 113 may perform wireless communication according to a communication scheme such as long-term evolution (LTE), LTE-advance (LTE-A), code division multiple access (CDMA), wideband CDMA (WCDMA), wireless broadband (WiBro), wireless fidelity (Wi-Fi), Bluetooth, near field communication (NFC), a global positioning system (GPS), or a global navigation satellite system (GNSS). For example, the communication circuit 113 may perform wired communication according to a communication scheme such as a universal serial bus (USB), a high definition multimedia interface (HDMI), recommended standard 232 (RS-232), a plain old telephone service (POTS), or the like. The communication circuit 113 may be omitted from the apparatus 110 depending on an embodiment.

Hereinafter, a processing system 100 using a surface mount technology (SMT) in which the screen printer 130 prints a printed circuit board will be briefly described. The screen printer 130 may include a workbench, a stencil (or metal mask), and a squeegee blade. When a printed circuit board is entered into the screen printer 130 and is fixed on the workbench, the stencil may be disposed on the printed circuit board so as to overlap the printed circuit board. The stencil may include a plurality of opening parts so as to print solder paste on only a predetermined area of the printed circuit board. The screen printer 130 may print solder paste on the stencil, and push the solder paste in the opening parts of the stencil by using the squeegee blade, so as to perform soldering on a pad of the printed circuit board. Subsequently, the screen printer may separate the stencil and the printed circuit board.

In the process of printing solder paste, remains of the solder paste may be accumulated in the opening parts of the stencil. The residual solder paste may be accumulated in the stencil while a plurality of printed circuit boards is printed, and the accumulated residual solder paste may affect a subsequent printing process. For example, when residual solder paste is accumulated in an opening part of the stencil, insufficiency of solder paste may occur. Clogging may occur, so that an opening part having a small area in the stencil may be clogged with residual solder paste, or excess of solder paste may occur since a gap between a printed circuit board and the stencil may be caused due to residual solder paste in an opening part having a large area. Therefore, soldering is inappropriately performed on a circuit board to be printed and the print quality may be low. To avoid the drawbacks, the screen printer 130 may be cleaned periodically. When a cleaning cycle for cleaning up residual solder paste is significantly short, a printing process may be delayed. When a cleaning cycle is significantly long, a problem in the print quality may occur. Accordingly, it is important to determine an appropriate length of a cleaning cycle so that a problem of print quality and a delay of print process do not occur.

In the present specification, cleaning the screen printer 130 may be cleaning the screen printer 130 and/or a stencil. In the process of printing a circuit board, when the screen printer 130 is periodically cleaned, clogging may be avoided. However, excessively frequent cleaning may cause a delay of a printing process and the screen printer 130 may need to be cleaned in appropriate cycles. Hereinafter, a method of determining an optimal cleaning cycle by measuring an anomaly score of a printed circuit board and using survival analysis will be described. A cleaning cycle may be a number of circuit boards that are printed after the screen printer 130 is cleaned once and before the screen printer 130 is cleaned again. The length of a cleaning cycle may be a number of printed circuit boards that are printed during a single cleaning cycle.

When a printed circuit board on which solder paste is printed is transferred from the screen printer 130 to an inspection device (solder paste inspection (SPI)) 120, the inspection device 120 may examine a printed state of solder paste in association with the transferred printed circuit board. For example, the inspection device 120 may emit light to a printed circuit board on which solder paste is printed, may receive light reflected from the printed circuit board, and may obtain two-dimensional and/or three-dimensional image data associated with the printed circuit board.

In addition, the inspection device 120 may compare the image data associated with a printed circuit board with a reference value or reference data for determining whether a printed state of solder paste is good or poor, so as to inspect whether solder paste printed on the printed circuit board is faulty. For example, the inspection device 120 examines whether solder paste printed on a printed circuit board has been applied to a precise location in an accurate amount, so as to inspect whether solder paste is faulty, and may generate measurement data indicating an inspection result.

According to an embodiment, the measurement data may include at least one of a volume, an area, a height, a width, or an inclination of solder paste printed by the screen printer 130.

The processor 111 may set up a communication connection with the inspection device 120 (hereinafter, "inspection device") by using the communication circuit 113, and may obtain measurement data from the inspection device 120. Here, the measurement data may include at least one of a degree of excess of printed solder paste, a degree of insufficiency of printed solder paste, a standard deviation in the amount of printed solder paste, a degree of deviation of a circuit board and a stencil from an aligned location, or a process capability index (capability of process, Katayori (CPK)). For example, the processor 111 may obtain measurement data associated with a degree of excess or insufficiency of solder paste printed on each of a plurality of pads included in a single printed circuit board, a standard deviation of the amount of the printed solder paste, and a degree of deviation of a circuit board and a stencil from an aligned location. The processor 111 may sequentially obtain, from the inspection device 120, measurement data associated with each of a plurality of printed circuit boards sequentially printed.

The processor 111 may determine, based on the measurement data, an anomaly score of a printed circuit board. The anomaly score of the printed circuit board may be a value indicating a print quality of the printed circuit board. For example, when the anomaly score of a printed circuit board is high, a relatively large number of pads in which excess or insufficiency of solder paste occurs are present in the corresponding printed circuit board, and a standard deviation in the amount of solder paste printed on a plurality of pads may be high. Conversely, when the anomaly score of a printed circuit board is low, a relatively small number of pads in which excess or insufficiency of solder paste occurs are present in the corresponding printed circuit board, and a standard deviation in the amount of solder paste printed on a plurality of pads may not be high. The processor 111 may determine a reference value for an anomaly score, and may determine a printed circuit board having an anomaly score higher than the reference value as a faulty printed circuit board. According to an embodiment, when a printed circuit board having an anomaly score higher than the reference value is printed, the processor 111 may determine that the screen printer 130 needs to be cleaned. Therefore, the processor 111 may determine a cleaning cycle for cleaning the screen printer 130 before a printed circuit board having an anomaly score higher than the reference value is printed.

Hereinafter, a process in which the processor 111 determines an anomaly score of a printed circuit board will be described in detail. To determine an anomaly score of a printed circuit board, the processor 111 may classify the pads of the printed circuit board into a plurality of pad groups according to the shapes of the pads of the printed circuit board. For example, the processor 111 may classify a plurality of pads of a printed circuit board into a first pad group including at least one pad provided in a first shape and a second pad group including at least one pad provided in a second shape.

According to an embodiment, the processor 111 may determine an anomaly score for each pad group, and may determine, based on the anomaly score for each pad group, an anomaly score of a printed circuit board. According to an embodiment, the processor 111 may determine a sum of anomaly scores of the respective pad groups as the anomaly score of the printed circuit board. For example, the processor 111 may determine an anomaly score of the first pad group and an anomaly score of the second pad group, and may determine the sum of the anomaly score of the first pad group and the anomaly score of the second pad group as the anomaly score of the printed circuit board. According to another embodiment, the processor 111 may determine a weight for each pad group, and may determine an anomaly score of a printed circuit board by taking into consideration the weight for each pad group. For example, the processor 111 may determine a weight for the first pad group and a weight for the second pad group, and may determine, as the anomaly score of the printed circuit board, the sum of a product of the weight and the anomaly score of the first pad group and a product of the weight and the anomaly score of the second pad group. According to an embodiment, the processor 111 may determine the weight for each pad group based on the number of pads included in each pad group. The processor 111 may set a weight for a pad group to be high when the number of pads included in the corresponding pad group is high. For example, when the number of pads included in the second pad group is higher than the number of pads included in the first pad group, the processor 111 may determine a weight for the second pad group to be higher than a weight for the first pad group. For example, when the number of pads included in a pad group is less than a predetermined number, the processor 111 may determine a weight for the corresponding pad group to be 0.

According to an embodiment, when determining an anomaly score of a pad group, the processor 111 may determine, based on measurement data, an anomaly score for each of at least one index for the corresponding pad group, and may determine, based on the anomaly score for each of at least one index, an anomaly score of the pad group. An anomaly score for each index may be a value indicating a degree of excess of printed solder paste, a degree of insufficiency of printed solder paste, a standard deviation in the amount of printed solder paste, a degree of deviation of a circuit board and a stencil from an aligned location, and a process capability index. For example, based on measurement data, the processor 111 may determine first data indicating a degree of excess of solder paste printed on at least one pad included in the first pad group, second data indicating a degree of insufficiency of solder paste printed on at least one pad included in the first group, third data indicating a standard deviation in solder paste printed on at least one pad included in the first pad group, fourth data indicating a degree of deviation of a printed circuit board and a stencil from an aligned location when solder paste is printed on at least one pad included in the first pad group, and fifth data indicating a process capability index of a process of printing solder paste on at least one pad included in the first pad group. Based on the first to fifth data, the processor 111 may determine an anomaly score of the first pad group. For example, the processor 111 may determine a value obtained by adding the first data to the fifth data as the anomaly score of the first pad group. According to another embodiment, the processor 111 may determine a weight for each index, and may determine an anomaly score of a pad group by taking into consideration the weight for each index. For example, the processor 111 may determine a weight for a first index and a weight for a second index, and may determine, as an anomaly score of a pad group, the sum of a product of first data corresponding to the first index and the weight for the first index and a product of second data corresponding to the second index and the weight for the second index.

In order to determine an anomaly score for each index, the processor 111 may set an estimation range for each index, and may determine, based on a degree of deviation of measurement data from the estimation range, an anomaly score for each index. The processor 111 may set an estimation range for each index by analyzing stored existing data.

According to an embodiment, the processor 111 may set an estimation range for each index via regression analysis. For example, the processor 111 may set an estimation range for each index by using Equation 1 below in order to estimate an amount (Y) of printed solder paste.

[Equation 1]

$$Y = a*X_1 + b*X_2 + c*X_3 + d*X_4 + e*X_5 + f$$

In Equation 1, $X_1$ denotes a direction of printing by the screen printer 130. For example, the screen printer 130 may print a circuit board in a forward direction (1) or in a backward direction (0). $X_2$ denotes the number of circuit boards printed after the latest cleaning of the screen printer 130. For example, when a cleaning cycle is 3, $X_2$ may have a value in a range of 1 to 3. $X_3$ to $X_5$ denote various variables (e.g., the pressure and the speed when a circuit board is printed, the speed of separation of a circuit board, or the like) related to the amount (Y) of solder paste printed on a circuit board. In this instance, $X_1$ to $X_5$ may not be limited to the above description and may include various variables capable of determining the amount (Y) of printed solder paste. Coefficients a, b, c, d, e, and f may be regression coefficients related to $X_1$ to $X_5$. The processor 111 may determine regression coefficients (a to f) by using stored existing data. For example, the processor 111 may identify, based on the stored existing data, a direction of printing by the screen printer 130, the number of circuit boards printed after the latest cleaning of the screen printer 130, and the pressure and speed when a circuit board is printed, and may determine regression coefficients by using the identified values.

According to an embodiment, an error may exist in the determined regression coefficients, and thus the processor 111 may determine, for each index, an estimation range (confidence interval) in which the value (Y) estimated based on Equation 1 is credible. The estimation range for each index may be a value obtained by estimating a range in which measurement data for each index varies depending on the number of circuit boards to be printed when a circuit board is printed without cleaning of the screen printer 130. Based on a degree of deviation of measurement data from an estimation range, the processor 111 may determine an anomaly score for each index. For example, the processor 111 may set an anomaly score for each index to be high when a degree of deviation of measurement data from an estimation range is high. Conversely, the processor 111 may set an anomaly score for each index to be low when measurement data is close to an estimation range.

According to the above-described process in which the processor 111 determines an anomaly score of a printed circuit board based on measurement data, the processor 111 may determine, based on a degree of deviation of measurement data from an estimation range, an anomaly score for each index, may determine, based on the anomaly score for each index, an anomaly score for each pad group, and may determine, based on the anomaly score for each pad group, an anomaly score of a printed circuit board. A method in which the processor 111 determines, based on measurement data, an anomaly score of a printed circuit board is not limited to the above-described embodiment, and may determine an anomaly score of a printed circuit board using various methods capable of measuring a print quality of a printed circuit board.

The processor 111 may generate estimated data based on an anomaly score. According to an embodiment, the processor 111 may generate estimated data using survival analysis. The estimated data may be data indicating an average quality loss each time printing of a single printed circuit board is performed when the length of a cleaning cycle is N. Survival analysis is a method for analyzing a period of time that elapses until a predetermined phenomenon occurs. When a printed circuit board is sequentially printed without cleaning of the screen printer 130, the processor 111 may use survival analysis in order to determine the point in time at which printing of a printed circuit board that has an anomaly score higher than a reference value is to be performed. According to an embodiment, when a printed circuit board is sequentially printed without cleaning, an anomaly score of a printed circuit board that is printed later may be higher. However, after a predetermined number of printed circuit boards are printed according to a set cleaning cycle, the screen printer 130 is cleaned. Therefore, it is difficult to directly calculate an anomaly score of a circuit board printed after a predetermined number of circuit boards are printed. Therefore, right censoring that cleans the screen printer 130 before an anomaly score reaches a predetermined value may occur. Accordingly, by utilizing survival analysis, an anomaly score when the number of circuit boards printed is greater than a predetermined number based on a cleaning cycle may be estimated, and estimated data may be generated based on the estimated anomaly score. For example, after cleaning is performed, the screen printer 130 may print a first printed circuit board that is printed first, a second printed circuit board that is printed second, and a third printed circuit board that is printed third within a single cleaning cycle when the length of a cleaning cycle is 3. At this time, the first printed circuit board may not have a quality loss since the first printed circuit board is printed immediately after cleaning and residual solder paste is not present in a stencil. However, the second printed circuit board may have a quality loss since residual solder paste may remain in the stencil during the process of printing the first printed circuit board. The third printed circuit board may also have a quality loss since residual solder paste is accumulated in the stencil during the process of printing the first printed circuit board and the second printed circuit board. At this time, estimated data may be generated by dividing, by the length of a cleaning cycle (e.g., 3), a value indicating a degree of a quality loss (e.g., the quality loss occurring in the second printed circuit board and the quality loss occurring in the third printed circuit board) occurring in all circuit boards printed during a single cleaning cycle. When a cleaning cycle is long, the amount of residual solder paste accumulated in the stencil may be high. Accordingly, estimated data may increase as the cleaning cycle is increased.

The processor 111 may determine an average time loss and an average resource loss. To clean the screen printer 130, a predetermined period of time may be required. During the period of time, the screen printer 130 may be incapable of printing a circuit board, and thus a loss is incurred. For example, during a period of time spent in cleaning the screen printer 130 once, a circuit board may not be printed and a loss that delays the entire process may be incurred. In addition, physical resources (e.g., a solvent, isopropyl alcohol (IPA), a cleaning paper, or the like) may be consumed for cleaning the screen printer 130 and a loss associated therewith may be incurred. The average time loss may be a value obtained by dividing, by the length of a cleaning cycle, a loss incurred due to a period of time spent in cleaning the screen printer 130. The average resource loss may be a value obtained by dividing, by the length of a cleaning cycle, a loss incurred due to the cost of resources consumed for cleaning the screen printer 130. The average time loss and the average resource loss may be low when the length of a cleaning cycle is long. A period of time spent in cleaning the screen printer 130 and the cost of physical resources consumed are constant, and thus the average time loss and the average resource loss may decrease as a cleaning cycle is increased.

According to an embodiment, the memory 112 may store data related to the time and cost consumed for cleaning the screen printer 130 once. The processor 111 may obtain, from the memory 112, the data related to the time and cost needed for cleaning, and may determine, based on the obtained data, an average time loss and an average resource loss depending on the length of a cleaning cycle.

Based on estimated data, an average time loss, and an average resource loss, the processor 111 may determine an optimal cleaning cycle. According to an embodiment, the processor 111 may, as an optimal cleaning cycle length, determine the length of a cleaning cycle that makes the sum of the estimated data, the average time loss, and the average resources loss to be a minimum value. For example, the optimal cleaning cycle may be determined using Equation 2 provided below.

[Equation 2]

$$L(n) = \frac{C_r \sum_1^n Q_n + t_d C_d + C_m}{t_p n + t_d}$$

L(n): an objective function for obtaining an optimal cleaning cycle
n: a length of a cleaning cycle
$C_r$: time and resources spent in additional cleaning when a printed circuit board having a quality loss is produced
$C_d$: a time loss incurred when cleaning a screen printer is performed once
$C_m$: a resource loss incurred when cleaning a screen printer is performed once
$Q_n$: a quality loss incurred in an $n^{th}$ printed circuit board
$t_d$: a time spent in cleaning a screen printer once
$t_p$: a time spent in printing a single printed circuit board

The processor 111 may update a cleaning cycle after cleaning is performed a predetermined number of times. According to an embodiment, the processor 111 may receive data indicating cleaning of the screen printer 130 from the screen printer 130 or the inspection device 120. When cleaning of the screen printer 130 is performed a predetermined number of times (e.g., 4 times), the processor 111 may update the length of a cleaning cycle by using measurement data accumulated.

The processor 111 may transmit information associated with a determined cleaning cycle to the screen printer 130, or may transmit commands to perform cleaning to the screen printer 130. According to an embodiment, the processor 111 may transmit the information associated with the determined cleaning cycle to the screen printer 130, so as to display the cleaning cycle on the display of the screen printer 130. In response to reception of the data associated with the cleaning cycle, the screen printer 130 may count the number of circuit boards printed, may suspend printing after circuit boards are printed as many times as the length of a cleaning cycle, and may clean a stencil. According to an embodiment, when cleaning is performed, the screen printer 130 may provide a notification associated with cleaning to a user via a display.

FIG. 2 is a diagram illustrating a stencil on which residual solder paste is accumulated, according to an embodiment of the present disclosure. In a process in which a screen printer prints solder paste on a plurality of printed circuit boards, residual solder paste may be accumulated in an opening part of a stencil 200. Referring to FIG. 2, the stencil 200 may include a plurality of opening parts corresponding to a plurality of pads provided in various areas and shapes, and residual solder paste may be accumulated in the plurality of opening parts. According to an embodiment, the effect of residual solder paste may be different depending on the area of an opening part. For example, clogging may occur due to residual solder paste in an opening part 201 having an area smaller than a predetermined size. Insufficiency of solder paste may occur in a pad corresponding to the opening part 201 through which solder paste does not smoothly pass due to clogging. Conversely, residual solder paste may be accumulated and hardened in a lateral side or a base side of an opening part 202 having an area larger than a predetermined size. Through the above, the stencil 200 and a printed circuit board may not be close to each other and excess of solder paste may occur.

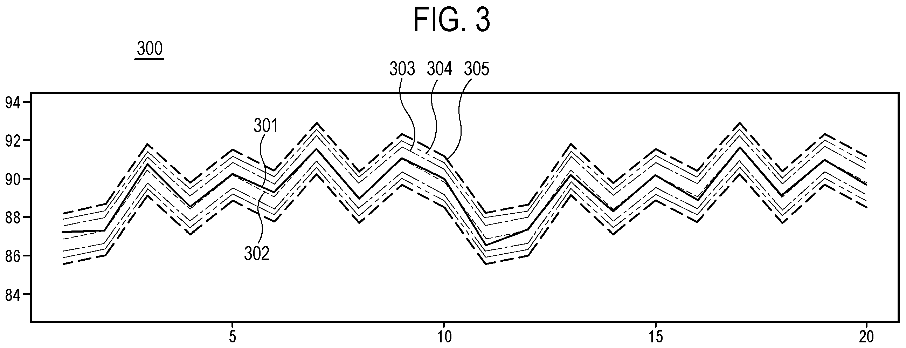

Accordingly, a screen printer may perform cleaning according to a predetermined cleaning cycle. Cleaning of the screen printer may be cleaning of the screen printer and/or stencil 200. The screen printer may obtain data associated with a cleaning cycle, and may perform cleaning based on the obtained data. Hereinafter, a method of determining an optimal cleaning cycle for a screen printer will be described in detail with reference to FIGS. 3 to 8.

FIG. 3 is a graph illustrating measurement data of an index indicating a state of solder paste and an estimation range, according to an embodiment of the present disclosure. A processor may obtain measurement data of an index indicating the state of solder paste from an inspection device. The index indicating the state of solder paste may include at least one of a degree of excess or insufficiency of solder paste printed on each of a plurality of pads included in a printed circuit board, a standard deviation in the amount of printed solder paste, a degree of deviation of a circuit board and a stencil from an aligned location, or a process capability index. The processor may determine, based on the obtained measurement data, an anomaly score for each index indicating the state of solder paste. Based on a difference between an estimated value 302 of an index indicating the state of solder paste and an actual value 301, the processor may determine an anomaly score for each index. For example, referring to FIG. 3, based on the amount of solder paste printed on a printed circuit board among measurement data, the processor may determine an anomaly score associated with a degree of excess of solder paste and a degree of insufficiency of solder paste. In FIG. 3, the x-axis denotes the number of printed circuit boards that a screen printer prints and the y-axis denotes the amount of solder paste printed on a printed circuit board. The amount of solder paste estimated (estimated value) 302 according to the number of circuit boards printed, error ranges 303, 304, and 305 of solder paste, and actual measurement value 301 based on measurement data are expressed in the form of a graph 300 in FIG. 3.

The processor may set confidence intervals 303, 304, and 405 respectively having predetermined error ranges based on the estimated value 302. For example, the processor may set the first confidence interval 303 having a first error range based on the estimate value, the second confidence interval 304 having a second error range, and the third confidence interval 305 having a third error range. The processor may set the estimated value 302 and confidence intervals 303, 304, and 305 respectively having predetermined error ranges by using existing data stored in a memory. Based on a difference between the measurement value 301 and the estimated value 302, the processor may determine an anomaly score of a printed circuit board. For example, in the graph of FIG. 3, the processor may determine an anomaly score associated with a degree of excess of solder paste when the measurement value 301 is higher than the estimated value 302, and may determine an anomaly score associated with a degree of insufficiency of solder paste when the measurement value 301 is lower than the estimated value 302. When an error value between the measurement value 301 and the estimated value 302 is high, the anomaly scores for the degrees of excess and insufficiency of solder paste may be determined to be high.

The processor may determine an anomaly score to be high when a difference between the estimated value 302 and the measurement value 301 is high. For example, a second anomaly score of a printed circuit board when the measurement value 301 falls within the second confidence interval 304 may be higher than a first anomaly score of the printed circuit board when the measurement value 301 falls within the first confidence interval 303, and a third anomaly score of the printed circuit board when the measurement value 301 falls within the third confidence interval 305 may be higher than the second anomaly score.

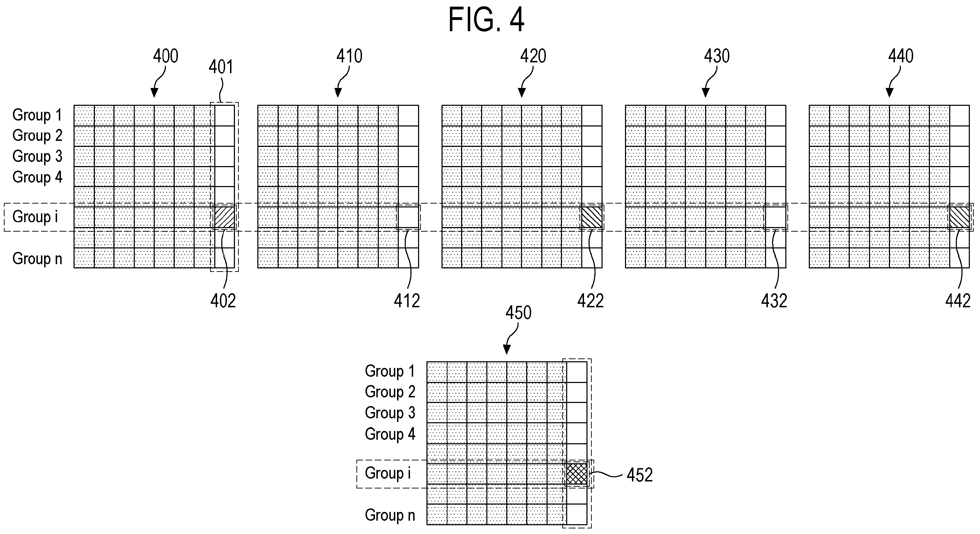

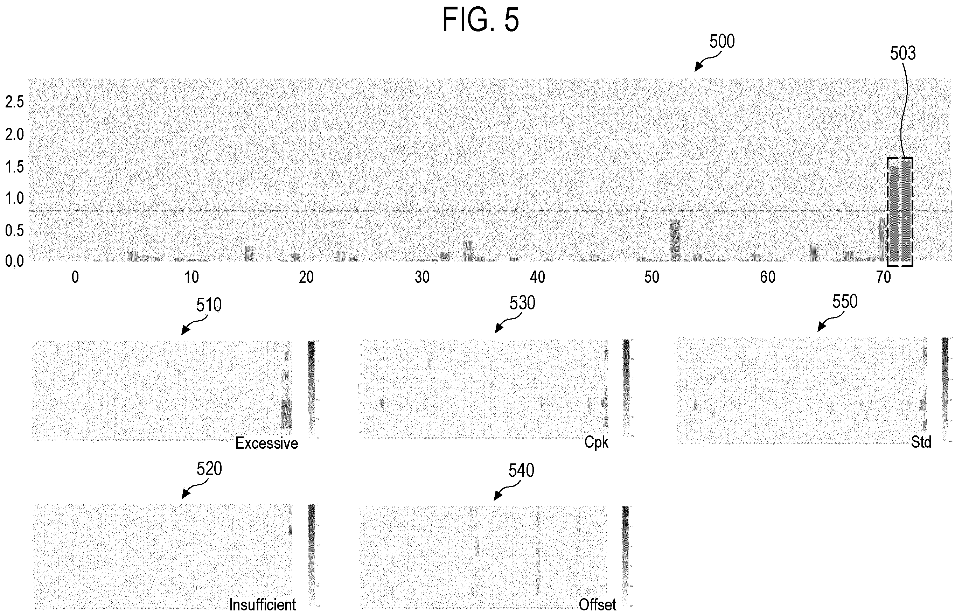

The processor may determine a cleaning cycle for a screen printer, and the screen printer may perform cleaning according to the determined cleaning cycle. For example, referring to FIG. 3, the processor may set the length of a cleaning cycle to 10. The screen printer may clean a stencil after printing 10 printed circuit boards, and it can be confirmed that the amount of solder paste printed on a printed circuit board dramatically decreased when the number of printed circuit boards reaches 10 in the group 300 of FIG. 3, as a result of cleaning. The processor may determine an anomaly score for another index indicating the state of solder paste in the same manner as the above-description. Various methods in which a processor determines an anomaly score of a printed circuit board will be described in detail with reference to FIGS. 4 and 5.

FIG. 4 is a diagram illustrating an embodiment in which an apparatus according to an embodiment of the present disclosure determines an anomaly score for each pad group, and determines an anomaly score of a circuit board based on the anomaly score for each pad group. A processor may classify a plurality of pads included in a printed circuit board into at least one pad group (e.g., group 1, group 2, ..., group n). Each pad group may include at least one pad having the same shape. The processor may determine an anomaly score for each pad group. The processor may determine, based on measurement data, an anomaly score for each pad group, and may determine, based on the anomaly score for each pad group, an anomaly score of a printed circuit board. According to an embodiment, the processor may arrange, based on the size of an area, the plurality of pad groups as first pad group to an $n^{th}$ pad group. For example, the first pad group may include a pad having the largest area among all pad groups, and the $n^{th}$ pad group may include a pad having the smallest area among all pad groups. However, the method of arranging the plurality of pad groups is not limited thereto.

Each matrix of FIG. 4 may be a matrix used when a processor determines an anomaly score of a printed circuit board. Each matrix 400, 410, 420, 430, and 440 in the upper part of the drawing corresponds to an index indicating the state of solder paste, and a matrix 450 in the lower part is a matrix that includes the data of all the matrices 400, 410, 420, 430, and 440 in the upper part. For example, the first matrix 400 may correspond to a degree of excess of solder paste, the second matrix 410 may correspond to a degree of insufficiency of solder paste, the third matrix 420 may correspond to a process capability index, the fourth matrix 430 may correspond to a degree of deviation of a circuit board and a stencil from an aligned location, the fifth matrix 440 may correspond to a standard deviation in the amount of solder paste, and each cell of the first matrix 400 to the fifth matrix 440 may correspond to an anomaly score associated with an index corresponding to a corresponding matrix. For example, each cell of a matrix may store an anomaly score for an index corresponding to the matrix. The matrix 450 in the lower part may store a result of integrating the data associated with the anomaly scores stored in the first matrix 400 to the fifth matrix 440. For example, each cell in a single column in the matrix 450 in the lower part may be an anomaly score of a single pad group in a single printed circuit board.

Each column of a matrix may correspond to a single printed circuit board. For example, a first column 401 of the first matrix 400 may store an anomaly score of the latest printed circuit board. Each row of a matrix may correspond to one of a plurality of pad groups included in a printed circuit board. For example, first rows of the first matrix 400 to the fifth matrix 440 may store anomaly scores for a first pad group among the plurality of pad groups.

The processor may determine an anomaly score for each index with respect to at least one pad that belongs to a pad group. For example, the processor may determine anomaly scores for a plurality of indices with respect to an $i^{th}$ pad group. A cell 402 at the $i^{th}$ row and the first column of the first matrix may store an anomaly score indicating a degree of excess of solder paste printed on pads belonging to the $i^{th}$ pad group of the latest printed circuit board. A cell 412 at the $i^{th}$ row and the first column of the second matrix may store an anomaly score indicating a degree of insufficiency of solder paste printed on the pads. In the cells 402, 412, 422, 432, and 443 at the $i^{th}$ rows and the first columns of the first matrix to the fifth matrix, the processor may store anomaly scores for respective indices with respect to the pads belonging to the $i^{th}$ pad group, respectively.

The processor may determine an anomaly score for each pad group by integrating the anomaly scores for respective indices. For example, the processor may integrate the anomaly score 402 for a first index to the anomaly score 442 for a fifth index with respect to the $i^{th}$ pad group, and may determine an anomaly score 452 of the $i^{th}$ pad group. In the matrix, the processor may integrate anomaly score stored in the cells 402, 412, 422, 432, and 442 at the $i^{th}$ row and the first column of the first matrix 400 to the fifth matrix 440, and may determine data to be stored in the cell 452 at the $i^{th}$ row and the first column of the matrix 450 in the lower part. According to an embodiment, the processor may set a weight for each index, and may determine an anomaly score for each pad group by using the weight. The processor may add a product of an anomaly score and a weight for each index of a pad group, and may determine an anomaly score of the corresponding pad group.

The processor may integrate an anomaly score of each pad group included in a printed circuit board and may determine an anomaly score of the printed circuit board. According to an embodiment, the processor may set a weight for each pad group, and may determine an anomaly score of a printed circuit board in consideration of the weight. For example, based on the number of pads included in each pad group, the processor may determine a weight for each pad group. For example, the processor may set a weight for each pad group to be high when the number of pads included in the pad group is high. According to an embodiment, the processor may determine an anomaly score of a printed circuit board by multiplying an anomaly score and a weight for each pad group and adding all the results of multiplication.

FIG. 5 is a diagram illustrating an embodiment in which an apparatus according to an embodiment of the present disclosure determines an anomaly score of a printed circuit board according to measurement data of an index indicating the state of solder paste. A detailed description which overlaps the description that has been described with reference to FIG. 4 will be omitted. FIG. 5 illustrates an embodiment that determines an anomaly score of a printed circuit board by using a matrix that has been described with reference to FIG. 4. FIG. 5 illustrates a first matrix 510 to a fifth matrix 550 corresponding to a plurality of indices indicating the state of solder paste, and illustrates a graph 500 indicating an anomaly score of a printed circuit board that is determined by integrating the first matrix 510 to the fifth matrix 550.

The first matrix 510 may show an anomaly score for each pad group in association with a degree of excess of solder paste, the second matrix 520 is associated with a degree of insufficiency of solder paste, the third matrix 530 is associated with a process capability index, the fourth matrix 540 is associated with a degree of deviation of a printed circuit board and a stencil from an aligned location, and the fifth matrix 550 is associated with a standard deviation in the amount of printed solder paste. In a matrix, each cell may be marked to be thick when an anomaly score of the corresponding cell is high. The processor may determine an anomaly score of a printed circuit board by integrating the anomaly scores for respective indices of respective matrices.

In the graph 500, the x-axis denotes the number of printed circuit boards, and the y-axis denotes an anomaly score. In the graph 500, it is identified that anomaly scores 503 of 71st and 72nd printed circuit boards are higher than a reference value. In response to determining that the anomaly scores 503 of the 71st and 72nd printed circuit boards are higher than the reference value, the processor may determine a cleaning cycle for a screen printer.

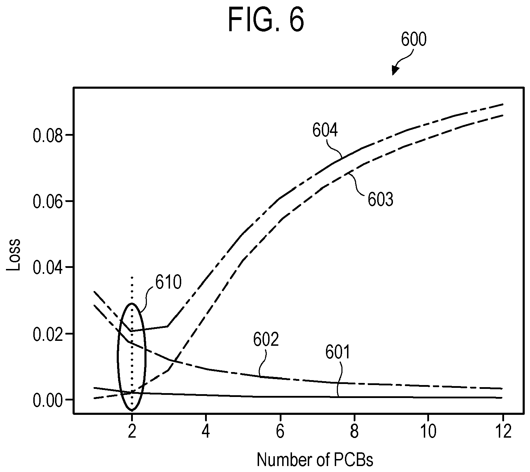

FIG. 6 is a diagram illustrating an embodiment in which an apparatus according to an embodiment of the present disclosure determines an optimal cleaning cycle based on measurement data and the amount of resources consumed for cleaning a screen printer, using survival analysis. A processor may generate estimated data based on an anomaly score, and may calculate an average time loss 602 and an average resource loss 601 so as to determine an optimal cleaning cycle. FIG. 6 illustrates a graph 600 that describes a method in which a processor determines an optimal cleaning cycle based on estimated data 603, the average time loss 602, and the average resource loss 601.

Using survival analysis, the processor may calculate an anomaly score of an $N^{th}$ printed circuit board after printing N circuit boards without cleaning of a screen printer, and may generate estimated data 603 which is a value indicating a degree of quality loss of the $N^{th}$ printed circuit board. Referring to FIG. 6, in the case in which a printed circuit board is continuously printed without cleaning of a screen printer, the amount of solder paste accumulated in a stencil may increase. Accordingly, the estimated data 603 may be expressed in a graph that extends to the right and upwards.

Based on the time and resource spent in cleaning a screen printer once, the processor may determine the average time loss 602 and the average resource loss 601. According to an embodiment, the processor may obtain, from a memory, data related to the time and resource spent in cleaning a screen printer once. The time and the resource to be spent is fixed, and thus the average time loss 602 obtained by dividing, by a cleaning cycle, a loss incurred due to time spent and the average resource loss 601 obtained by dividing, by the cleaning cycle, a loss incurred due to resources consumed may decrease as the cleaning cycle is increased. Accordingly, the average time loss 602 and the average resource loss 601 in the graph 600 of FIG. 6 may be expressed as a graph that extends to the right and downwards.

The processor may determine, as the optimal cleaning cycle, a cleaning cycle that makes the sum of the estimated data 603, the average time loss 602, and the average resource loss 601 to be the minimum value. Referring to FIG. 6, a total loss 610 is the lowest value when a cleaning cycle is 2 and thus the processor may determine 2 as the cleaning cycle.

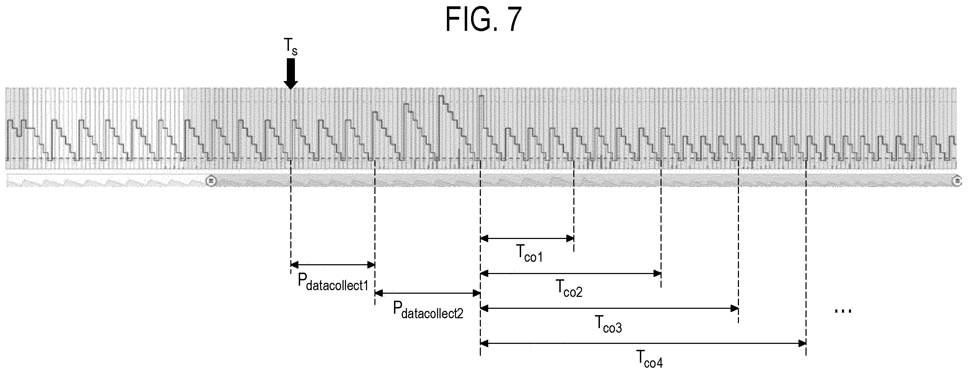

FIG. 7 is a diagram illustrating an embodiment in which an apparatus according to an embodiment of the present disclosure determines an optimal cleaning cycle by using measurement data and survival analysis. A processor may obtain measurement data from an inspection device. According to an embodiment, after starting ($T_s$) a sequence for determining an optimal cleaning cycle, the processor may collect measurement data during a first data collection interval ($P_{datacollect1}$) in which cleaning of a screen printer is performed a predetermined number of times (e.g., three times). In the first data collection interval ($P_{datacollect1}$), the processor may obtain measurement data from an inspection device, but may not calculate an anomaly score. According to an embodiment, based on the measurement data obtained in the first data collection interval ($P_{datacollect1}$), the processor may set an estimation range for each index in order to determine an anomaly score.

The processor may collect data by increasing a cleaning cycle in a second data collection interval ($P_{datacollect2}$). According to an embodiment, the second data collection interval ($P_{datacollect2}$) may be a period in which cleaning of a screen printer is performed a predetermined number of times. According to an embodiment, the processor may confirm whether the estimated data is identical to the actual measurement value in the second data collection interval ($P_{datacollect2}$) using survival analysis.

After termination of the first and second data collection intervals ($P_{datacollect1}$, $P_{datacollect2}$), the processor may determine an optimal cleaning cycle for the screen printer as provided in the above-description. Referring to FIG. 7, the processor may determine 4 as the length of a cleaning cycle. According to an embodiment, the processor may update a cleaning cycle after the screen printer is cleaned a predetermined number of times. The processor may update the cleaning cycle by using all the accumulated data, when updating the cleaning cycle. For example, referring to FIG. 7, the processor may update the cleaning cycle after cleaning is performed 4 times. At a first cleaning cycle update point, the processor may update the cleaning cycle based on data accumulated during a period ($T_{co1}$) from the termination of the second data collection interval ($P_{datacollect2}$) to the first update point. At a second cleaning cycle update point, the processor may update the cleaning cycle based on data accumulated during a period ($T_{co2}$) from the termination of the second data collection interval ($P_{datacollect2}$) to the second update point. In the same manner, at a third update point and a fourth update point, the cleaning cycle may be updated by using all the accumulated data. Through the above, the processor may determine a cleaning cycle that reflects the current state of the screen printer, and may always maintain an optimal cleaning cycle.

Various embodiments of the present disclosure may be embodied by software in a machine-readable storage medium. The software may be software to embody the various embodiments of the present disclosure. The software may be inferred from the various embodiments of the present disclosure by programmers in the technical field to which the present disclosure pertains. For example, the software may be programs including machine-readable instructions (e.g., codes or code segments). The machine may be a device capable of operating according to an instruction retrieved from a storage medium, and may be, for example, a computer. According to an embodiment, the machine may be the apparatus 110 according to various embodiments of the present disclosure. According to an embodiment, the processor of the machine may execute the retrieved instruction so that components of the machine perform a function corresponding to the corresponding instruction. According to an embodiment, the processor may be the processor 111 according to various embodiments of the present disclosure. The storage medium may be all types of machine-readable recording media storing data. The storage medium may include, for example, a ROM, a RAM, a CD-ROM, a magnetic tape, a floppy disk, an optical data storage device, and the like. According to an embodiment, the storage medium may be the memory 112. According to an embodiment, the storage medium may be embodied in a form of being dispersed to a computer system or the like connected over a network. The software may be dispersed and stored in a computer system or the like, and may be executed. The storage medium may be a non-transitory storage medium. The non-transitory storage medium may be a tangible medium irrespective of whether data is semi-permanently or temporarily stored, and may exclude a signal propagated in a transitory manner.

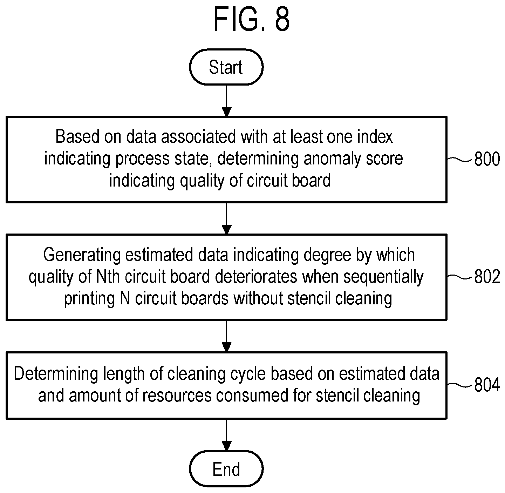

FIG. 8 is a flowchart illustrating a method of determining an optimal cleaning cycle by an apparatus according to an embodiment of the present disclosure. According to an embodiment, in operation 800, based on data associated with at least one index indicating the state of a process, an apparatus may determine an anomaly score indicating a quality of a circuit board. The apparatus may obtain measurement data in association with a plurality of indices indicating the state of solder paste from an inspection device. The apparatus may set, based on stored data, an estimated value and an estimation range of data for each index, and may determine an anomaly score based on a difference between the measurement value and the estimated value.

According to an embodiment, the apparatus may classify, based on a shape, a plurality of pads included in a printed circuit board into a plurality of pad groups, and may determine an anomaly score for each pad group. The apparatus may determine an anomaly score for each index and may integrate an anomaly score for each index, so as to determine an anomaly score of a pad group. According to an embodiment, the apparatus may determine a weight for each index and may determine an anomaly score of a pad group by using the weight for each index. For example, the apparatus may determine, as an anomaly score for each pad group, a value obtained by multiplying an anomaly score and a weight for each index and adding all results of multiplication. The apparatus may determine an anomaly score of a printed circuit board by integrating an anomaly score of each pad group. According to an embodiment, the apparatus may determine a weight for each pad group, and may determine an anomaly score of a printed circuit board in consideration of the determined weight. For example, the apparatus may determine, as an anomaly score of a printed circuit board, a value obtained by multiplying an anomaly score and a weight for each pad group and adding all results of the multiplication.

According to an embodiment, in operation 802, the apparatus may generate estimated data indicating a degree of a quality loss of an $N^{th}$ circuit board when sequentially printing N circuit boards without cleaning a screen printer. Using survival analysis, the apparatus may estimate an anomaly score of a printed circuit board of which actual measurement data is not obtained. Based on the estimated anomaly score, the apparatus may generate estimated data indicating a degree of a quality loss of the printed circuit board.

According to an embodiment, in operation 804, based on the estimated data and the time and the amount of resources consumed for cleaning the screen printer, the apparatus may determine the length of a cleaning cycle. The apparatus may calculate an average time loss and an average resource loss that vary according to the length of a cleaning cycle, and may determine, as an optimal cleaning cycle, a cleaning cycle that makes the sum of the average time loss, the average resource loss, and the estimated data to be a minimum value.

According to an embodiment, the apparatus may update a cleaning cycle after the screen printer is cleaned a predetermined number of times. Based on the state of the screen printer or the state of a printed circuit board, an optimal cleaning cycle may be changed. Accordingly, the apparatus may update a cleaning cycle after cleaning is performed a predetermined number of times. The apparatus may update a cleaning cycle based on all measurement data accumulated until an updating point.

Although a method according to the present disclosure or each operation of an algorithm is described in a sequential order in the flowchart of FIG. 8, the operations may be performed sequentially or may also be performed in an order that is arbitrarily combined according to the present disclosure. The description based on the flowchart does not exclude a change or a modification of a method or an algorithm, and may not imply that a predetermined operation is not essential or preferable. According to an embodiment, at least some operations may be performed in parallel, repeatedly, or heuristically. According to an embodiment, at least some operations may be omitted or another operation may be added.

Although the technical spirit of the present disclosure has been described with reference to the above-described various embodiments, the technical spirit of the present disclosure may include various types of substitutions, modifications, and changes that may be made within a range understandable by those skilled in the technical field to which the present disclosure belongs. In addition, it should be construed that the replacement, modifications, and changes are included in the attached claims.

**Claims**

1.  An apparatus comprising:

    one or more processors; and
    one or more memories storing instructions, which, when executed by the one or more processors, enable the one or more processors to perform an operation,
    wherein the one or more processors are configured to:

    based on at least one index indicating states of solder paste printed on a plurality of circuit boards, determine a plurality of anomaly scores indicating print qualities of the plurality of circuit boards, respectively;
    based on the plurality of anomaly scores, generate estimated data indicating a degree of deterioration of a print quality of an Nth circuit board when sequentially printing N circuit boards without cleaning a screen printer; and
    determine a cleaning cycle based on the estimated data and an amount of resources consumed when cleaning of the screen printer is performed, and
    wherein the cleaning cycle corresponds to a number of circuit boards printed by the screen printer after the screen printer is cleaned and before a start of subsequent cleaning.

2.  The apparatus of Claim 1, wherein the one or more processors are further configured to:

    determine a weight corresponding to each of the at least one index;
    determine an estimation range of the at least one index; and
    based on the weight and a degree by which each of the at least one index deviates from the estimation range, determine the plurality of anomaly scores of the plurality of circuit boards, respectively.

3.  The apparatus of Claim 2, wherein the one or more processors are further configured to:

    determine an anomaly score for each of a plurality of pad groups distinguished based on a shape of a pad; and
    based on the anomaly score for each of the plurality of pad groups, determine the plurality of anomaly scores of the plurality of circuit boards, respectively.

4.  The apparatus of Claim 3, wherein the one or more processors are further configured to:

    based on a number of pads included in each of the plurality of pad groups, determine a weight for each pad group; and
    based on the anomaly score and the weight for each of the plurality of pad groups, determine the plurality of anomaly scores for the plurality of circuit boards, respectively.

5.  The apparatus of Claim 4, wherein the one or more processors are further configured to:
    determine a weight for a pad group, of which the number of pads included in the pad group is less than or equal to a predetermined number among the plurality of pad groups, to be 0.

6.  The apparatus of Claim 1, wherein the at least one index comprises at least one among a degree of excess of printed solder paste, a degree of insufficiency of printed solder paste, a standard deviation in an amount of printed solder paste, and a degree of deviation of a circuit board and a stencil from an aligned location.

7. The apparatus of Claim 1, further comprising a communication circuit connected to be capable of communicating with the screen printer,

   wherein the communication circuit is configured to transmit the cleaning cycle to the screen printer, and
   wherein the screen printer is configured to, in response to reception of the cleaning cycle, perform a predetermined operation for cleaning based on the cleaning cycle.

8. The apparatus of Claim 1, wherein the one or more processors are further configured to generate the estimated data using survival analysis.

9. The apparatus of Claim 1, wherein the resources consumed when cleaning of the screen printer is performed includes a cost for purchasing items and a time needed for cleaning the screen printer.

10. The apparatus of claim 9, wherein the one or more processors are further configured to:
    determine, based on the estimated data and the cost for purchasing items and the time needed for cleaning the screen printer, the cleaning cycle so that the amount of resources consumed for cleaning the screen printer and deterioration in print quality are minimized.

11. The apparatus of claim 1, wherein the one or more processors are configured to:

    continuously obtain the at least one index and store the at least one index in the one or more memories; and
    update the cleaning cycle based on data stored in the one or more memories, after cleaning is performed a predetermined number of times.

12. A method comprising:

    based on at least one index indicating states of solder paste printed on a plurality of circuit boards, determining a plurality of anomaly scores indicating print qualities of the plurality of circuit boards, respectively;
    based on the plurality of anomaly scores, generating estimated data indicating a degree of deterioration of a quality of an Nth circuit board when sequentially printing N circuit boards without cleaning a screen printer; and
    determining a cleaning cycle based on the estimated data and an amount of resources consumed when cleaning of the screen printer is performed,
    wherein the cleaning cycle corresponds to a number of circuit boards printed by the screen printer after the screen printer is cleaned and before a start of subsequent cleaning.

13. The method of Claim 12, wherein the determining the plurality of anomaly scores comprises:

    determining a weight corresponding to each of the at least one index;
    determining an estimation range of the at least one index; and
    based on the weight and a degree by which each of the at least one index deviates from the estimation range, determining the plurality of anomaly scores of the plurality of circuit boards, respectively.

14. The method of Claim 13, wherein the determining the plurality of anomaly scores further comprises:

    determining an anomaly score for each of a plurality of pad groups distinguished based on a shape of a pad; and
    based on the anomaly score for each of the plurality of pad groups, determining the plurality of anomaly scores of the plurality of circuit boards, respectively.

15. The method of Claim 14, wherein the determining the plurality of anomaly scores further comprises:

    based on a number of pads included in each of the plurality of pad groups, determining a weight for each pad group; and
    based on the anomaly score and the weight for each of the plurality of pad groups, determining the plurality of anomaly scores for the plurality of circuit boards, respectively.

16. The method of Claim 15, wherein the determining the weight for each of the plurality of pad groups further comprises:
    determining a weight for a pad group, of which the number of pads included in the pad group is less than or equal to a predetermined number among the plurality of pad groups, to be 0.

17. The method of Claim 12, wherein the at least one index comprises at least one among a degree of excess of printed solder paste, a degree of insufficiency of printed solder paste, a standard deviation in an amount of printed solder paste, and a degree of deviation of a circuit board and a stencil from an aligned location.

18. The method of Claim 12, wherein the generating the estimated data comprises:
generating the estimated data using survival analysis.

19. The method of Claim 12, wherein the determining the cleaning cycle comprises:

continuously obtaining the at least one index and storing the at least one index in one or more memories; and based on data stored in the one or more memories, updating the cleaning cycle after cleaning is performed a predetermined number of times.

20. A non-transitory computer-readable recording medium that stores instructions which, when executed by one or more processors, enable the one or more processors to perform an operation, wherein the instructions include operations in which the one or more processors are configured to:

based on at least one index indicating states of solder paste printed on a plurality of circuit boards, determine a plurality of anomaly scores indicating print qualities of the plurality of circuit boards, respectively;
based on the plurality of anomaly scores, generate estimated data indicating a degree of deterioration of quality of an Nth circuit board when sequentially printing N circuit boards without cleaning a screen printer, and determine a cleaning cycle based on the estimated data and an amount of resources consumed when cleaning of the screen printer is performed,
wherein the cleaning cycle corresponds to the number of circuit boards printed by the screen printer after the screen printer is cleaned and before subsequent cleaning.

# FIG. 1

<u>100</u>

# FIG. 2

<u>200</u>

FIG. 3

FIG. 4

EP 4 598 285 A1

# FIG. 5

EP 4 598 285 A1

FIG. 6

## FIG. 7

# FIG. 8

Start

Based on data associated with at least one index indicating process state, determining anomaly score indicating quality of circuit board ~800

Generating estimated data indicating degree by which quality of Nth circuit board deteriorates when sequentially printing N circuit boards without stencil cleaning ~802

Determining length of cleaning cycle based on estimated data and amount of resources consumed for stencil cleaning ~804

End

## INTERNATIONAL SEARCH REPORT

| International application No. |
| --- |
| **PCT/KR2023/015150** |

**A.     CLASSIFICATION OF SUBJECT MATTER**

**H05K 3/26**(2006.01)i; **H05K 1/11**(2006.01)i

According to International Patent Classification (IPC) or to both national classification and IPC

**B.     FIELDS SEARCHED**

Minimum documentation searched (classification system followed by classification symbols)

H05K 3/26(2006.01); B41F 15/08(2006.01); B41F 33/00(2006.01); G06K 15/00(2006.01); G06T 7/00(2006.01); H05K 13/08(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 스크린 프린터(screen printer), 솔더 페이스트(solder paste), 불량 점수(anomaly score), 가중치(weight), 세척 주기(cleaning cycle)

**C.     DOCUMENTS CONSIDERED TO BE RELEVANT**

| Category* | Citation of document, with indication, where appropriate, of the relevant passages | Relevant to claim No. |
| --- | --- | --- |
| A | US 2022-0161544 A1 (FUJI CORPORATION) 26 May 2022 (2022-05-26)<br>See paragraph [0037]; and claim 5. | 1-20 |
| A | KR 10-2014-0128745 A (PARMI CO., LTD.) 06 November 2014 (2014-11-06)<br>See paragraph [0167]. | 1-20 |
| A | US 2015-0009524 A1 (YAMAHA HATSUDOKI KABUSHIKI KAISHA) 08 January 2015 (2015-01-08)<br>See claim 1. | 1-20 |
| A | KR 10-2019-0075641 A (KOH YOUNG TECHNOLOGY INC.) 01 July 2019 (2019-07-01)<br>See claim 1. | 1-20 |
| A | WO 2018-147712 A1 (KOH YOUNG TECHNOLOGY INC.) 16 August 2018 (2018-08-16)<br>See claim 1. | 1-20 |

☐ Further documents are listed in the continuation of Box C.     ☑ See patent family annex.

| | |
| --- | --- |
| *    Special categories of cited documents:<br>"A"  document defining the general state of the art which is not considered to be of particular relevance<br>"D"  document cited by the applicant in the international application<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
| --- | --- |
| **08 January 2024** | **08 January 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2023/015150**

| Patent document cited in search report | | | Publication date (day/month/year) | Patent family member(s) | | | Publication date (day/month/year) |
|---|---|---|---|---|---|---|---|
| US | 2022-0161544 | A1 | 26 May 2022 | CN | 113710487 | A | 26 November 2021 |
| | | | | CN | 113710487 | B | 21 October 2022 |
| | | | | CN | 113710489 | A | 26 November 2021 |
| | | | | CN | 113710489 | B | 24 February 2023 |
| | | | | EP | 3960457 | A1 | 02 March 2022 |
| | | | | EP | 3960457 | A4 | 04 May 2022 |
| | | | | EP | 3960458 | A1 | 02 March 2022 |
| | | | | EP | 3960458 | A4 | 06 July 2022 |
| | | | | JP | 7183402 | B2 | 05 December 2022 |
| | | | | JP | 7194820 | B2 | 22 December 2022 |
| | | | | US | 2022-176689 | A1 | 09 June 2022 |
| | | | | WO | 2020-217510 | A1 | 29 October 2020 |
| | | | | WO | 2020-217570 | A1 | 29 October 2020 |
| KR | 10-2014-0128745 | A | 06 November 2014 | None | | | |
| US | 2015-0009524 | A1 | 08 January 2015 | CN | 104136221 | A | 05 November 2014 |
| | | | | CN | 104136221 | B | 18 May 2016 |
| | | | | EP | 2818320 | A1 | 31 December 2014 |
| | | | | EP | 2818320 | A4 | 19 August 2015 |
| | | | | EP | 2818320 | B1 | 13 December 2017 |
| | | | | JP | 2013-169723 | A | 02 September 2013 |
| | | | | JP | 5917941 | B2 | 18 May 2016 |
| | | | | US | 9082070 | B2 | 14 July 2015 |
| | | | | WO | 2013-124942 | A1 | 29 August 2013 |
| KR | 10-2019-0075641 | A | 01 July 2019 | CN | 109952019 | A | 28 June 2019 |
| | | | | CN | 109952019 | B | 15 September 2020 |
| | | | | EP | 3501828 | A1 | 26 June 2019 |
| | | | | EP | 3501828 | B1 | 12 February 2020 |
| | | | | KR | 10-2106349 | B1 | 04 May 2020 |
| | | | | US | 10684321 | B2 | 16 June 2020 |
| | | | | US | 2019-0195939 | A1 | 27 June 2019 |
| WO | 2018-147712 | A1 | 16 August 2018 | CN | 110291855 | A | 27 September 2019 |
| | | | | CN | 110291855 | B | 14 September 2021 |
| | | | | CN | 113763335 | A | 07 December 2021 |
| | | | | EP | 3582599 | A1 | 18 December 2019 |
| | | | | EP | 3582599 | A4 | 15 January 2020 |
| | | | | EP | 3582599 | B1 | 30 March 2022 |
| | | | | KR | 10-2019-0105093 | A | 11 September 2019 |
| | | | | KR | 10-2021-0095975 | A | 03 August 2021 |
| | | | | KR | 10-2285760 | B1 | 05 August 2021 |
| | | | | KR | 10-2317464 | B1 | 28 October 2021 |
| | | | | US | 10997714 | B2 | 04 May 2021 |
| | | | | US | 11481893 | B2 | 25 October 2022 |
| | | | | US | 2019-0362482 | A1 | 28 November 2019 |
| | | | | US | 2021-295490 | A1 | 23 September 2021 |

Form PCT/ISA/210 (patent family annex) (July 2022)